# EUROPEAN PATENT APPLICATION

(11) **EP 4 394 880 A1**
(43) Date of publication of application: **03.07.2024**
(21) Application number: 22216888.2
(22) Date of filing: 28.12.2022
(51) Int. Cl.: H01L 29/06, H01L 29/40, H01L 29/423, H01L 29/78

(54) **SEMICONDUCTOR DEVICE**

(71) Applicant: Nexperia B.V., 6534 AB Nijmegen (NL)
(72) Inventor: Pandey, Deepak Chandra, Manchester (GB); Hsu, Chih-Wei, Manchester (GB); Siddiqui, MD Imran, Manchester, SK7 5BJ (GB)
(74) Representative: Pjanovic, Ilija

(57) **Abstract**

A semiconductor power device comprising a drift region of a first conductivity type, a body region of a second conductivity type disposed over the drift region, wherein the second conductivity type is opposite to the first conductivity type, at least two gate trench regions in contact with the body region and the drift region, wherein two laterally adjacent gate trench regions are separated by a mesa region, a contact region of a first conductivity type located in the mesa region and disposed over the body region, wherein the contact region has a higher doping concentration compared to the doping concentration of the drift region, and wherein the contact region is in contact with the two adjacent gate trench regions so that, in use, a channel is formed along each gate trench region and within the body region;
a source contact disposed over the contact region, and an auxiliary gate region formed within the mesa region.

## Description

The present disclosure relates to a trench-gate semiconductor device and a method for manufacturing trench-gate semiconductor devices. Particularly but not exclusively, the present disclosure relates to a trench-gate metal-oxide-semiconductor field-effect transistor (MOSFET) having an auxiliary gate disposed in a mesa region between two trench gates.

### Background

Trench metal-oxide-semiconductor field-effect transistors (MOSFETs), are widely known and used in many applications. In a trench MOSFET, current is conducted vertically from one surface of the MOSFET to the other surface of the MOSFET.

Trench MOSFETs may be used for many different applications. Regardless of the application, it may be desirable for a transistor to be as efficient as possible, so that energy consumption to operate the transistor within the context of its application may be reduced. This may for example be achieved by reducing the resistance of the transistor. Elements contributing to the resistance of the transistor include (but are not limited to) the channel body region, and the drift region. As technology has advanced, scaling down of the channel body resistance has been a challenge for current trench MOSFETs. This means that the contribution of the channel body resistance may significant, especially in low voltage applications.

In state-of-the-art devices, current flows along the inversion layer formed on the sidewalls of the gate trenches within the trench MOSFET. In the mesa region between adjacent gate trenches, there can be a dead zone in which no conduction channel is formed-

### Summary

Aspects and preferred features are set out in the accompanying claims.

According to a first aspect of the invention there is provided a semiconductor power device comprising: a drift region of a first conductivity type; a body region of a second conductivity type disposed over the drift region, wherein the second conductivity type is opposite to the first conductivity type; at least two gate trench regions in contact with the body region and the drift region, wherein two laterally adjacent gate trench regions are separated by a mesa region; a contact region of a first conductivity type located in the mesa region and disposed over the body region, wherein the contact region has a higher doping concentration compared to the doping concentration of the drift region, and wherein the contact region is in contact with the two adjacent gate trench regions so that, in use, a channel is formed along each gate trench region and within the body region; a source contact disposed over the contact region; and an auxiliary gate region formed within the mesa region.

The device according to the aspect of the invention may provide a reduced channel resistance, for the same threshold and breakdown voltage.

The auxiliary gate region may extend from a surface of the contact region to a first depth within the device. The first depth may be substantially smaller than a total depth of the gate trench regions within the device.

Each gate trench region may comprise a gate conductive region formed in an upper portion of each gate trench region, and a gate insulation layer formed along sidewalls and a lower surface of each gate trench region.

Each gate trench region may further comprise a shield electrode in a lower portion of each gate trench region. The shield electrode may be insulated from the drift region by the gate insulation layer. The shield electrode may be insulated from the gate electrode by an insulation layer disposed over the shield electrode.

The upper portion may extend to a second depth within the device. The second depth may be substantially equal to the depth of the body region within the device.

The auxiliary gate region may extend from a surface of the contact region to a first depth within the device. The upper portion may extend to a second depth within the device. The first depth may be equal to or smaller than the second depth.

Between two adjacent gate trench regions, the auxiliary gate region may comprise a single auxiliary trench gate.

Between two adjacent gate trench regions, the auxiliary gate region may comprise a plurality of auxiliary trench gates.

Between two adjacent gate trench regions, the auxiliary gate region may have a width that is equal to or greater than 40% of a width of the mesa region.

The at least two gate trench regions may be laterally spaced in a first dimension. Current may flow in the device in a second dimension substantially transverse to the first dimension. The gate trench regions may extend in a third dimension of the device.

The source contact may be spaced from the auxiliary gate region in the third dimension.

The device may further comprise additional auxiliary gate trench regions located laterally either side of the gate trench regions. The device may further comprise additional source contacts located laterally either side of the gate trench regions.

The additional auxiliary gate trench regions may be in line with the auxiliary gate trench region in the third dimension. The additional source contacts may be in line with the source contact in the third dimension.

The additional auxiliary gate trench regions may be in line with the source contact in in the third dimension. The additional source contacts may be in line with the auxiliary gate trench region in the third dimension.

The device may further comprise a metal gate contact layer electrically connected to the auxiliary gate trench and the additional auxiliary trench gate regions.

The device may further comprise a metal source contact layer electrically connected to the source contact.

The metal gate contact layer and the metal source contact layer may be formed in a same plane in the second dimension. The device may further comprise an insulation region located laterally in between the gate contact layer and the metal source contact layer.

The semiconductor device may comprise a metal-oxide-semiconductor field-effect transistor (MOSFET). The semiconductor device may comprise an insulated-gate bipolar transistor. The semiconductor device may comprise a gated device.

According to a second aspect of the invention there is provided a method of manufacturing a semiconductor power device, the method comprising forming a drift region of a first conductivity type, forming a body region of a second conductivity type over the drift region, wherein the second conductivity type is opposite to the first conductivity type, forming at least two gate trench regions in contact with the body region and the drift region, wherein two laterally adjacent gate trench regions are separated by a mesa region, forming a contact region of a first conductivity type located in the mesa region and disposed over the body region, wherein the contact region has a higher doping concentration compared to a doping concentration of the drift region, and wherein the contact region is in contact with the two adjacent gate trench regions so that, in use, a channel is formed along each gate trench region and within the body region, forming a source contact disposed over the contact region, and forming an auxiliary gate region formed within the mesa region.

Forming an auxiliary gate region formed within the mesa region may comprise depositing a photoresist layer over a surface of the device, developing a mask in the photoresist layer, such that at least one area within the mesa region is exposed, and performing an etching process to form at least one recess defining the auxiliary gate region.

Features of different aspects of the invention may be combined together.

### Brief Description of the Drawings

Some embodiments of the disclosure will now be described, by way of example only and with reference to the accompanying drawings, in which:
Figure 1 shows schematically a cross-section of a semiconductor device, along the line A-A' shown in Figure 2, according to an embodiment of the disclosure;
Figure 2 shows schematically a top-view of a semiconductor device according to an embodiment of the disclosure;
Figure 3 shows schematically a cross-section of a semiconductor device, along the line B-B' shown in Figure 2, according to an embodiment of the disclosure;
Figure 4 shows schematically a top-view of an alternative semiconductor device according to an embodiment of the disclosure;
Figure 5 shows schematically a perspective view of a semiconductor device according to an embodiment of the disclosure;
Figure 6 shows schematically a perspective view of an alternative semiconductor device according to an embodiment of the disclosure; and
Figures 7(a) to (g) illustrate steps of a method for manufacturing a semiconductor device according to an embodiment of the disclosure.

### Detailed Description of the Preferred Embodiments

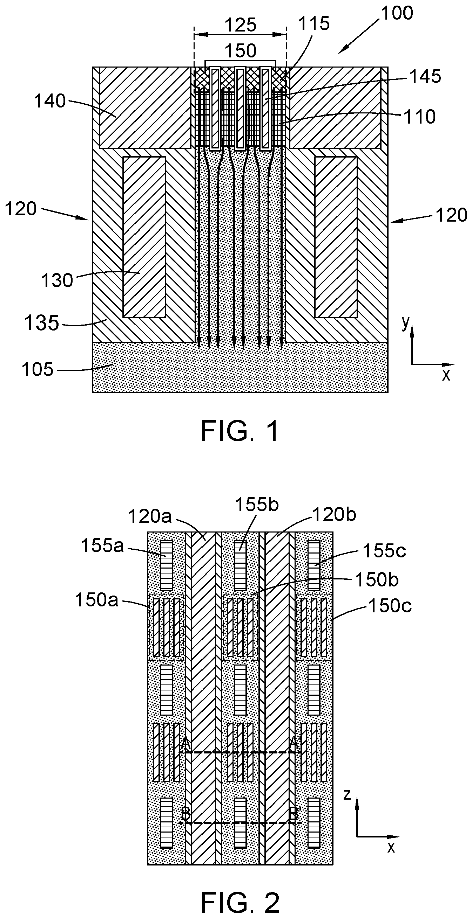

Figure 1 shows schematically a cross-section of a semiconductor device 100, along the line A-A' shown in Figure 2, according to an embodiment of the disclosure. In this example, the device is a silicon based trench-gate MOSFET. However, the skilled person would understand that the device may comprise alternative semiconductor materials; for example, the device may be silicon carbide (SiC) based or Gallium Nitride (GaN) based. The device may be an insulated-gate bipolar transistor or a gated device.

The device 100 includes a n-type voltage sustaining region (or n-drift region) 105. In this example, the n-drift region 105 is an epitaxial layer. Whilst not shown, the device may include a drain or collector region located underneath the drift region 105. The device 100 includes two gate trenches 120 extending downwardly into the n-drift region 105 from an upper surface of an n+ contact region 115. During operation, a conduction channel is formed between the n+ contact region 115 and the drift region 105 by application of a positive voltage to the gate.

Above the n-drift region 105, and adjacent to the gate trenches 120, there is a provided a p-body region 110. The p-body region 110 is a p-type doped semiconductor and generally extends to a depth in the device which generally corresponds with the depth of the gate conductive region 140. The depth of the p-body region 110 may be less than the depth of the gate conductive region 140 in order to ensure that the gate conductive region 140 is able to provide switching along the full depth of the p-body region 110. The n+ contact region 115 is formed above the p-body region 110.

Two gate trenches 120 are formed, which are laterally spaced from each other in an x-dimension. Each gate trench 120 includes an insulation layer 135 formed along the inner sidewalls and the lower surface of the gate trench 120. In this example the insulation layer 135 is an oxide layer (e.g. silicon dioxide), though other insulating materials may be used. In examples where the insulation layer 135 is a silicon dioxide liner, the silicon dioxide liner 135 may be thermally grown.

The gate trenches 120 include a conductive region 140 formed in an upper portion of each trench 120, and a trench shield 130 formed in a lower portion of each trench 120. The polysilicon region 140 and the trench shield 130 of each trench are separated by the insulation layer 135. The conductive region 140 and the trench shield may be formed of a conducting material, such as metal or doped polysilicon.

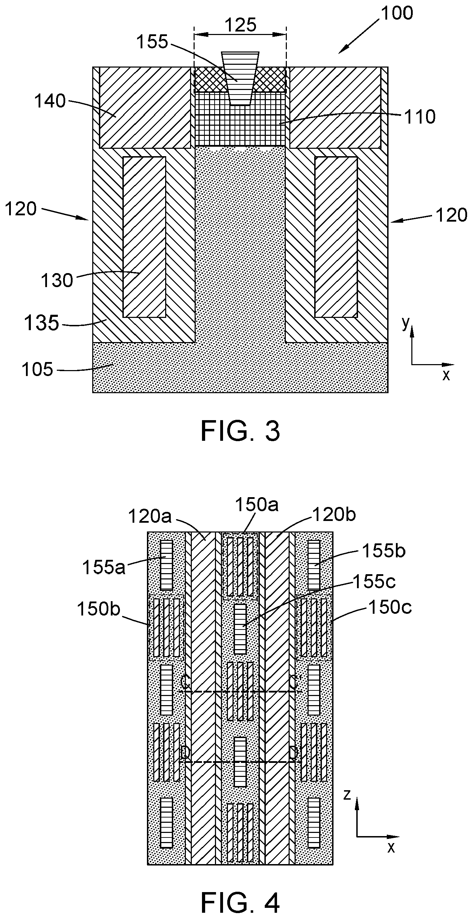

Figure 2 shows schematically a top-view of the semiconductor device of Figure 1, and Figure 3 shows schematically a cross-section of the semiconductor device of Figure 1, along the line B-B' shown in Figure 2.

Adjacent gate trenches 120 are separated by a mesa region 125. As shown in Figures 2 and 3, a source contact 155 is formed within the mesa region 125 laterally between adjacent trenches 120 and extends into the p-body region 110.

As can be seen, the gate trenches 120 are elongate and extend in the z-dimension. Multiple source contacts 155 may be provided between two gate trenches 120, spaced from each other in the z-direction. Between adjacent source contacts 155, and spaced from the source contacts 155 in the z-direction, three auxiliary gates 145a, 145b, 145c are provided. The three auxiliary gates 145a, 145b, 145c may be referred to as an auxiliary gate structure 150. Whilst three auxiliary gates 145a, 145b, 145c are shown in each auxiliary gate structure 150 between each set of adjacent gate trenches 120, it will be understood that more or less auxiliary gates may be provided within each auxiliary gate structure. The number of auxiliary gates can be determined by the width of the mesa region. In the depicted example, the three auxiliary gates may be provided for a mesa region width of around 500nm. In general, one gate may be provided for each 150nm +/-50nm of the mesa region width.

Simulations were performed for a 40V device having a baseline specific total resistance (including the substrate, drift, and channel resistance) of 4.97Ωmm². When one auxiliary gate was inserted between adjacent gate trenches, the specific total resistance was reduced to 4.35Ωmm² for same threshold and breakdown voltage. showing a 12.5% reduction in specific resistance. When two auxiliary gates were inserted between adjacent gate trenches, the specific total resistance was reduced to 4.12Ωmm² for same threshold and breakdown voltage, showing a 17.1% reduction in specific resistance. In general, the greater number of auxiliary gates used increases the conduction channel area within the mesa region and further reduces the channel resistance of the device.

The auxiliary gates 145 are each formed of a conductive region 160 surrounded by an insulating layer 165. The conductive region of the gate trenches 140 and the trench shield 130 may be formed of a conducting material, such as metal or doped polysilicon The conductive region 160 of the auxiliary gates 145 may be formed of the same material as the conductive region 140 of the gate trenches 120, and the insulating layer 165 of the auxiliary gates 145 may be formed of the same material as the insulating layer 135 of the gate trenches 120. The thickness of the insulating layers 135, 165 of the gate trenches and the auxiliary trenches can be adjusted to support the breakdown voltage of the device.

During operation, the conduction channel is formed between the n+ contact region 115 and the drift region 105; within the p-body region 110 the conduction channel is formed along the sidewalls of the gate trenches 120 and the auxiliary gates 145. The auxiliary gates 145 increase the area along which the conduction channel is formed within the p-body region 110 by providing multiple inversion layers and thus multiple conduction channels through the device, compared to state-of-the-art devices in which no auxiliary gates are present. This reduces both the channel resistance and the drift resistance of the device. The auxiliary gates ensure that more of the channel area and upper drift region is utilized, and that there is a reduced amount of unused area within the p-body region 110 and the n-drift region 105. This allows a larger current to flow through the device for given gate potential, such that drain-source on resistance (RDS(on)) is reduced.

In examples where the auxiliary gates 145 occupy 50% of the width of the mesa region 125 and the n+ contact region 115 occupies 50% of the width of the mesa region 125, the channel resistance is reduced by approximately 50%.

The auxiliary gates 145 may extend beyond the p-body region 110. The auxiliary gates 145 may be within the p-body region 110.

The device 100 may be formed as a die which measures 2mm x 2mm or more when viewed from above. The gate trenches 120 may for example be provided with a pitch of 0.6 microns or more. The gate trenches 120 may for example have a width of 0.3 microns or more, and may for example have a depth of 1.5 microns or more. The mesa region 123 may for example have a width of 0.3 microns or more. An insulating layer 165 of the auxiliary gates 145 may for example have a thickness of 30 nm or more. The auxiliary gates may for example have a depth of 0.5 microns or more. The epitaxial layer 105 may for example have a thickness of 0.6 microns or more.

In the example of Figure 2, source contacts 155 are provided laterally in between adjacent gate trenches 120, as well as being provided either side of two adjacent gate trenches 120. In other words, in a first region along the semiconductor device 100 in the z-direction, across the semiconductor device 100 in an x-direction there may be provided a source contact 155a, a gate trench 120a, a source contact 155b, a gate trench 120b, and a further source contact 155c.

Similarly, an auxiliary gate structure 150 of auxiliary gates 145 is provided laterally in between adjacent gate trenches 120, as well as being provided either side of two adjacent gate trenches 120. In other words, in a second region along the semiconductor device 100 in the z-direction, across the semiconductor device 100 in an x-direction there may be provided an auxiliary gate structure 150a, a gate trench 120a, an auxiliary gate structure 150b, a gate trench 120b, and a further auxiliary gate structure 150c.

In the examples shown in Figure 2 and Figure 4, the first region along the semiconductor device 100 in the z-direction is adjacent to the second region along the semiconductor device 100 in the z-direction, such that source contacts and auxiliary gate structures are formed in an alternating pattern in the z-direction.

Figure 4 shows schematically a top-view of an alternative semiconductor device according to an embodiment of the disclosure. Many of the features are similar to those shown in Figure 2 and therefore carry the same reference numerals. A cross-section along the line C-C' shown in Figure 4 would be similar to the cross-section shown in Figure 1, and a cross-section along the line D-D' shown in Figure 4 would be similar to the cross-section shown in Figure 3.

As can be seen, the gate trenches 120 are elongate and extend in the z-dimension. Multiple source contacts 155 may be provided between two gate trenches 120, spaced from each other in the z-direction. Between adjacent source contacts 155, and spaced from the source contacts 155 in the z-direction, auxiliary gate structures 150 are provided.

In the example of Figure 4, source contacts 155 are provided laterally in between adjacent gate trenches 120, as well as being provided either side of two adjacent gate trenches 120. However, the source contacts 155 that are located either side of two adjacent gate trenches 120 are provided in line with the auxiliary gate structures 150 that are provided laterally in between adjacent gate trenches 120. Similarly, auxiliary gate structures 150 is provided laterally in between adjacent gate trenches 120, as well as being provided either side of two adjacent gate trenches 120. However, the auxiliary gate structures 150 that are located either side of two adjacent gate trenches 120 are provided in line with the source contacts 155 that are provided laterally in between adjacent gate trenches 120. In other words, in a first region along the semiconductor device 100 in the z-direction, across the semiconductor device 100 in an x-direction there may be provided a source contact 155a, a gate trench 120a, an auxiliary gate structure 150a, a gate trench 120b, and a further source contact 155b. In a second region along the semiconductor device 100 in the z-direction, across the semiconductor device 100 in an x-direction there may be provided an auxiliary gate structure 150b, a gate trench 120a, a source contact 155c, a gate trench 120b, and a further auxiliary gate structure 150c.

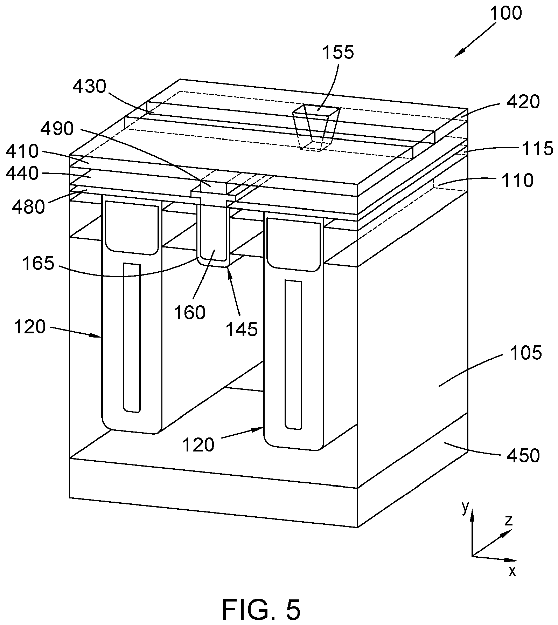

Figure 5 shows schematically a perspective view of a semiconductor device according to an embodiment of the disclosure. Many of the features are similar to those shown in Figure 1 and therefore carry the same reference numerals. Whilst the example shown in figure 1 includes three auxiliary gates within the auxiliary gate structure, the device shown in Figure 5 includes one auxiliary gate 145 between adjacent gate trenches 120.

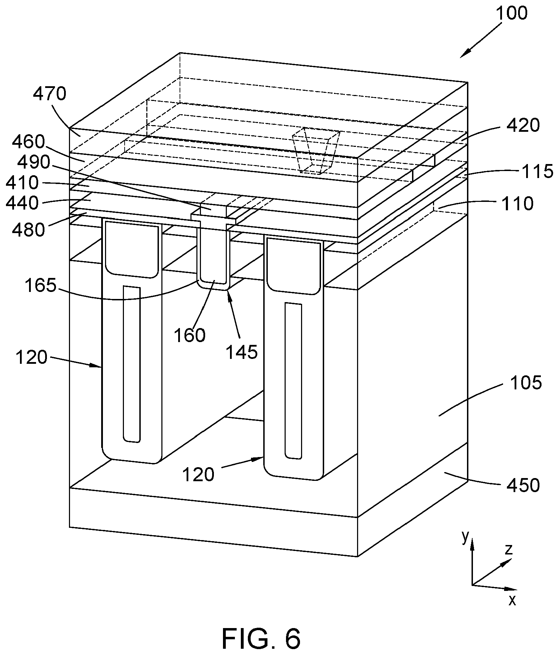

It will be understood that the additional features shown in Figures 5 and 6 can be equally applied to the embodiments shown in Figures 1 to 4.

A collector layer 450, also referred to as a drain or substrate, is formed under the n-drift region 105. The conductive region 160 of the auxiliary gate 145 extends above an upper surface of the n+ contact region 115 and is electrically connected to a gate contact layer 410. In the example shown in Figure 5, the conductive region 160 is electrically coupled with the gate contact layer 410 using a conductive block 490. The auxiliary gate 145 and the gate trenches 120 may be electrically connected at an edge of the device through a conducting via, or may be electrically connected laterally by joining the auxiliary gate 145 and gate trench 120 using a conducting layer.

The source contact 155 extends above an upper surface of the n+ contact region 115 and is electrically connected to a source contact layer 420. An insulation region 430 is provided in between the gate contact layer 410 and the source contact layer 420. The gate contact layer 410 and the source contact layer 420 may be formed of a conductive material, such as metal.

An interlayer dielectric 440 is disposed over an upper surface of the gate trenches 120 and the n+ contact region 115, is located between the upper surface of the gate trenches 120 and the n+ contact region 115 and a lower surface of the gate contact layer 410 and the source contact layer 420.

Figure 6 shows schematically a perspective view of an alternative semiconductor device according to an embodiment of the disclosure. Many of the features are similar to those shown in Figure 5 and therefore carry the same reference numerals.

An insulation layer 460 (which may be referred to as a dielectric layer) is disposed over the gate contact layer 410 and the insulation region 430. A metal layer 470 is disposed over the insulation layer 460.

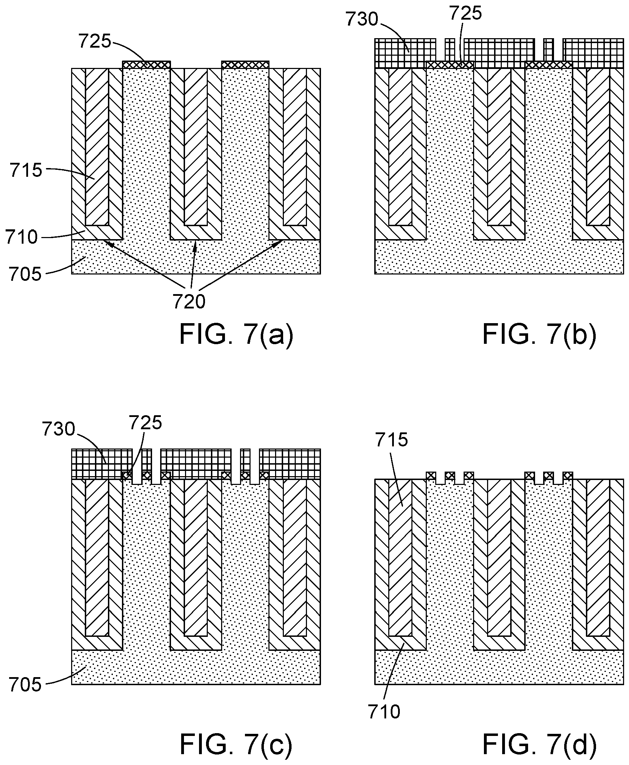

Figures 7(a) to (g) illustrate steps within a method for manufacturing a semiconductor device according to an embodiment of the disclosure.

Figure 7(a) illustrates the first step of manufacturing the semiconductor device, which is as follows:
(a) Step 1
   - A semiconductor substrate 705 is provided. In an example, the substrate is silicon. The semiconductor substrate may be an epitaxial layer.
   - A plurality of trenches 720 are etched and filled with an insulating liner 710 conductive region 715. In an example, the conductive region comprises polysilicon and the insulating layer comprises silicon dioxide.
   - A chemical-mechanical polishing (CMP) process is performed to planarise the surface of the filled trenches 720 and the semiconductor substrate 705.
   - A nitride layer 725 is formed over the mesa region between adjacent gate trenches.

Figure 7(b) illustrates the second step of manufacturing the semiconductor device, which is as follows:
(b) Step 2
- A photoresist layer 730 is deposited over an upper surface of the device.
- The photoresist layer 730 is patterned and subsequently developed such that a mask covers an upper surface of the device, leaving the areas where auxiliary trenches are to be located exposed.

Figure 7(c) illustrates the third step of manufacturing the semiconductor device, which is as follows:
(c) Step 3 An etch process is performed to remove the nitride layer 725 in regions where the photoresist 730 is not present, and where the auxiliary trenches are to be located. The etch process stops at or just below an upper surface of the semiconductor substrate 705.

Figure 7(d) illustrates the fourth step of manufacturing the semiconductor device, which is as follows:
(d) Step 4 The photoresist layer is removed from the upper surface of the device.

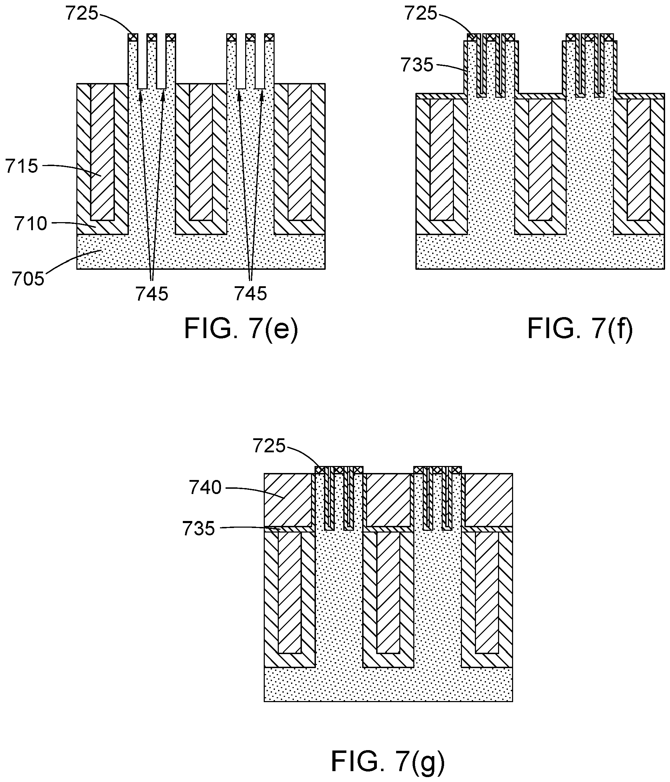

Figure 7(e) illustrates the fifth step of manufacturing the semiconductor device, which is as follows:
(e) Step 5 A recess etch is performed to remove an upper portion of the conductive region 715 and the insulating liner 710 from the trenches. The recess etch process removes the semiconductor substrate 705 in areas not covered by the nitride layer 725, to form the auxiliary trenches 745. The etchant used has an etch selectively such that the nitride layer 725 stops the etchant from removing the remaining semiconductor substrate 705 in the mesa region.

Figure 7(f) illustrates the sixth step of manufacturing the semiconductor device, which is as follows:
(f) Step 6 An insulating layer 735 is formed over the device on the exposed substrate 705, using an oxidation process. In an example, the insulating layer comprises silicon dioxide.

Figure 7(g) illustrates the seventh step of manufacturing the semiconductor device, which is as follows:
(g) Step 7
A second conductive region 740 is deposited over the insulating layer 735 and within each of the trenches 720, 745. In an example, the second conductive region comprises polysilicon.
The second conductive region 740 is deposited such that an upper surface of the second conductive region 740 within the gate trenches 720 is below an upper surface of the nitride layer 725.

Whilst Figures 7(a) to 7(g) illustrate steps within a method of manufacturing a semiconductor device according to an embodiment of the disclosure, they are not exhaustive and the method of manufacturing may include further steps both before and after the steps shown in Figures 7(a) to 7(g).

The skilled person will understand that in the preceding description and appended claims, positional terms such as 'above', 'overlap', 'under', 'lateral, etc. are made with reference to conceptual illustrations of an apparatus, such as those showing standard cross-sectional perspectives and those shown in the appended drawings. These terms
are used for ease of reference but are not intended to be of limiting nature. These terms are therefore to be understood as referring to a device when in an orientation as shown in the accompanying drawings.

It will be appreciated that all doping polarities mentioned above could be reversed, the resulting devices still being in accordance with embodiments of the present invention.

In this document, dimensions are provided merely as indicative examples, and are not intended to be limiting.

Although the disclosure has been described in terms of preferred embodiments as set forth above, it should be understood that these embodiments are illustrative only and that the claims are not limited to those embodiments. Those skilled in the art will be able to make modifications and alternatives in view of the disclosure, which are contemplated as falling within the scope of the appended claims. Each feature disclosed or illustrated in the present specification may be incorporated in the disclosure, whether alone or in any appropriate combination with any other feature disclosed or illustrated herein

### Reference Numerals

- 100: semiconductor device
- 105: n-drift region
- 110: p-body region
- 115: n+ contact region
- 120: gate trench
- 125: mesa region
- 130: trench shield
- 135: insulation layer
- 140: gate conductive region
- 145: auxiliary gate
- 150: auxiliary gate structure
- 155: source contact
- 160: conductive region
- 165: insulation layer
- 410: gate contact layer
- 420: source contact layer
- 430: insulation region
- 440: interlayer dielectric
- 450: collector layer
- 460: insulation layer
- 470: metal layer
- 480: insulation layer
- 490: conductive block
- 705: semiconductor substrate
- 710: insulating liner
- 715: first conductive region
- 720: gate trenches
- 725: nitride layer
- 730: photoresist layer
- 735: insulating layer
- 740: second conductive region
- 745: auxiliary trench

## Claims

1. A semiconductor power device comprising:
a drift region of a first conductivity type;
a body region of a second conductivity type disposed over the drift region, wherein the second conductivity type is opposite to the first conductivity type;
at least two gate trench regions in contact with the body region and the drift region, wherein two laterally adjacent gate trench regions are separated by a mesa region;
a contact region of a first conductivity type located in the mesa region and disposed over the body region, wherein the contact region has a higher doping concentration compared to the doping concentration of the drift region, and wherein the contact region is in contact with the two adjacent gate trench regions so that, in use, a channel is formed along each gate trench region and within the body region;
a source contact disposed over the contact region; and
an auxiliary gate region formed within the mesa region.

2. The device according to claim 1, wherein the auxiliary gate region extends from a surface of the contact region to a first depth within the device, wherein the first depth is substantially smaller than a total depth of the gate trench regions within the device.

3. The device according to claim 1 or 2, wherein each gate trench region comprises a gate conductive region formed in an upper portion of each gate trench region, and a gate insulation layer formed along sidewalls and a lower surface of each gate trench region.

4. The device according to claim 3, wherein each gate trench region further comprises a shield electrode in a lower portion of each gate trench region, wherein the shield electrode is insulated from the drift region by the gate insulation layer, and wherein the shield electrode is insulated from the gate electrode by an insulation layer disposed over the shield electrode.

5. The device of claim 3 or 4, wherein the upper portion extends to a second depth within the device, wherein the second depth is substantially equal to the depth of the body region within the device.

6. The device according to any of claims 3 to 5, wherein the auxiliary gate region extends from a surface of the contact region to a first depth within the device, and wherein the upper portion extends to a second depth within the device, wherein the first depth is equal to or smaller than the second depth.

7. The device according to any preceding claim, wherein between two adjacent gate trench regions, the auxiliary gate region comprises a single auxiliary trench gate.

8. The device according to any preceding claim, wherein between two adjacent gate trench regions, the auxiliary gate region comprises a plurality of auxiliary trench gates.

9. The device according to any preceding claim, wherein between two adjacent gate trench regions, the auxiliary gate region has a width that is equal to or greater than 40% of a width of the mesa region.

10. The device according to any preceding claim, wherein the at least two gate trench regions are laterally spaced in a first dimension, wherein current flows in the device in a second dimension substantially transverse to the first dimension, and wherein the gate trench regions extend in a third dimension of the device.

11. The device according to claim 10, wherein the source contact is spaced from the auxiliary gate region in the third dimension.

12. The device according to claim 11, wherein the device further comprises additional auxiliary gate trench regions located laterally either side of the gate trench regions, and wherein the device further comprises additional source contacts located laterally either side of the gate trench regions.

13. The device according to claim 12, wherein the additional auxiliary gate trench regions are in line with the auxiliary gate trench region in the third dimension, and wherein the additional source contacts are in line with the source contact in the third dimension.

14. The device according to claim 12, wherein the additional auxiliary gate trench regions are in line with the source contact in in the third dimension, and wherein the additional source contacts are in line with the auxiliary gate trench region in the third dimension.

15. The device according to any of claims 12 to 14, further comprising a metal gate contact layer electrically connected to the auxiliary gate trench and the additional auxiliary trench gate regions.

16. The device according to claim 15, further comprising a metal source contact layer electrically connected to the source contact.

17. The device according to claim 16, wherein the metal gate contact layer and the metal source contact layer are formed in a same plane in the second dimension, and wherein the device further comprises an insulation region located laterally in between the gate contact layer and the metal source contact layer.

18. A device according to any preceding claim, wherein the semiconductor device comprises a metal-oxide-semiconductor field-effect transistor (MOSFET).

19. A method of manufacturing a semiconductor power device, the method comprising:
forming a drift region of a first conductivity type;
forming a body region of a second conductivity type over the drift region, wherein the second conductivity type is opposite to the first conductivity type;
forming at least two gate trench regions in contact with the body region and the drift region, wherein two laterally adjacent gate trench regions are separated by a mesa region;
forming a contact region of a first conductivity type located in the mesa region and disposed over the body region, wherein the contact region has a higher doping concentration compared to a doping concentration of the drift region, and wherein the contact region is in contact with the two adjacent gate trench regions so that, in use, a channel is formed along each gate trench region and within the body region;
forming a source contact disposed over the contact region; and
forming an auxiliary gate region formed within the mesa region.

20. A method of manufacturing a semiconductor device according to claim 19, wherein forming an auxiliary gate region formed within the mesa region comprises:
depositing a photoresist layer over a surface of the device;
developing a mask in the photoresist layer, such that at least one area within the mesa region is exposed;
performing an etching process to form at least one recess defining the auxiliary gate region.
